# EUROPEAN PATENT APPLICATION

(11) **EP 4 761 144 A1**
(43) Date of publication of application: **17.06.2026**
(21) Application number: 25220841.8
(22) Date of filing: 04.12.2025
(51) Int. Cl.: H04B 10/516, H04B 10/532, H04B 10/54, H03M 13/29, H03M 13/00

(54) **APPARATUS AND METHODS FOR CHANNEL ALLOCATION**

(30) Priority: 10.12.2024 US 202463730311 P
(71) Applicant: Infinera Corporation, San Jose, CA 95119 (US)
(72) Inventor: LAND, Ingmar, 92190 Meudon (FR); LE TRUNG, Khoa, 21121 Fontaine-les-Dijon (FR); SUN, Han, San Jose, 95119 (US)
(74) Representative: Novagraaf Technologies

(57) **Abstract**

Streams of data encoded by a plurality of OFEC encoders are merged and allocated among a plurality of optical subcarriers of an optical communication system having two polarization channels. Methods and apparatus are provided for performing the merging and allocating such that for each OFEC encoder of said OFEC encoder plurality, a same number of bits of encoded data is allocated to each subcarrier of the subcarrier plurality, and a same number of bits of encoded data is allocated to each of the two polarization channels.

## Description

### Technical Field

The disclosure relates to optical modems, and more particularly to implementations of high-speed multicarrier optical transmission and reception.

### Cross-Reference to Related Application

This application claims the benefit of Provisional Application Serial No. 63/730,311, filed on December 10, 2024.

### Art Background

There is continuing interest in increasing the capability of optical fiber communication systems for high-speed transmission. Standards for optical transmitters capable of data rates as high as 800G, i.e., 800 Gigabits per second, have been issued by standards bodies. Examples include the 800ZR Coherent Interface Implementation Agreement issued in 2024 by the Open Internet Forum, and the OpenROADM MSA 6.0 issued in 2023 by the OpenROADM Multi-Source Agreement (MSA) Group.

By way of example, 800G optical communication is used in modern networking technologies like Optical Transport Networks (OTN), Ethernet, and InfiniBand. Among other reasons, rates of 800G and above are of interest because they can provide ultra-high bandwidth for applications in data centers, cloud computing, high-performance computing (HPC), Artificial Intelligence (AI), and telecommunication networks.

The OIF 800ZR standard, the OpenROADM MSA 5.0 standard, and the OpenROADM MSA 6.0 standard, among others, use OpenFEC ("OFEC") as the coding scheme for forward error correction. Open ROADM has adopted the same implementation for metro optical transport applications.

Both OIF 800ZR and OpenROADM MSA 6.0 call for four digital processors operating in parallel to perform the OFEC coding and decoding, with each processor supporting a data rate of 200G.

There is interest in extending the capabilities of optical modems to 1.6T, i.e., transmission and reception at 1600 Gigabit per second, and to even higher rates. However, 1.6T capability places a heavy burden on the achievable rates of digital processing, particularly for single-carrier transmission systems. Interest has turned to systems using two or more subcarriers, because the consequent reduction in baudrate per carrier relaxes the demands on processor speed.

By way of example, the 1600ZR Implementation Agreement (IA) of the Open Internet Forum (OIF) details 1.6T capability with a single subcarrier, but it envisages a communication reach of only 80-120 km. On the other hand, the OIF Implementation Agreement oif2024.447.03 for 1600ZR+ Coherent Optical Interfaces, which describes both the 1600ZR+ and the 1200ZR+ implementations, prescribes two subcarriers, and it envisages reaches of 1000 km and 2000 km, respectively. These larger reaches have stronger requirements on the receiver-side digital signal processor (DSP). The reduced baudrate consequent on the use of multiple subcarriers brings the processing requirements, especially the receiver-side processing requirements, further within the range of technical feasibility.

One of the technical challenges encountered when introducing multiple subcarriers is how best to distribute the output data bits produced by the OFEC encoders and the OFEC interleavers across the two or more subcarriers. Unless the algorithms for the merging and interleaving of these data bits are devised with care, they may lead to sub-optimal performance. There is a continuing need for improved approaches to the distribution of OFEC encoder and OFEC interleaver outputs across multiple subcarriers.

### Summary

In a first aspect, the present disclosure relates to a method in which at least an input stream A and an input stream B of sequentially ordered input data units of data encoded by a plurality of OFEC encoders are merged so as to produce at least a first merged stream and a second merged stream of sequentially ordered output data units.

In a first allocation scheme, the first merged stream is allocated to an optical subcarrier SC0 and the second merged stream is allocated to an optical subcarrier SC1 of an optical communication system having two polarization channels, wherein the optical subcarriers SC0 and SC1 belong to a plurality of at least two optical subcarriers, and each of the input data units comprises one or more blocks of encoded data.

In the merging, input data units from the respective input streams are assigned to the respective merged streams by round robin distribution. The producing of each of the output data units comprises merging input data units assigned to a given merged stream, such that each output data unit comprises the encoded data blocks of one input data unit from each of the respective input streams.

The merging and allocating are carried out such that for each OFEC encoder of said OFEC encoder plurality, a same number of bits is allocated to each subcarrier of the subcarrier plurality, and a same number of bits is allocated to each of the two polarization channels.

In some embodiments, the allocating of merged streams is periodically alternated between the first allocation scheme and a second allocation scheme in which the first merged stream is allocated to SC1 and the second merged stream is allocated to SC0.

In some such embodiments, each input data unit is an 8-bit DP-16QAM word. **In** other embodiments, each input data unit consists of two sequential 8-bit DP-16QAM words.

In some such embodiments, each input data unit is an 8-bit DP-16QAM word, there are four input streams A, B, C, and D of sequentially ordered input data units; and streams A, B, C, and D are merged so as to produce a first merged stream and a second merged stream of sequentially ordered output data units.

In some such embodiments, each input data unit consists of two 8-bit DP-16QAM words; there are four input streams A, B, C, and D of sequentially ordered input data units; streams A, B, C, and D are merged so as to produce first, second, third, and fourth merged streams of sequentially ordered output data units. In the first allocation scheme, the first merged stream is allocated to SC0, the second merged stream is allocated to SC1, the third merged stream is allocated to a third subcarrier SC2 of the subcarrier plurality, and the fourth merged stream is allocated to a fourth subcarrier SC3 of the subcarrier plurality. In the second allocation scheme, the first merged stream is allocated to SC1, the second merged stream is allocated to SC0, the third merged stream is allocated to a third subcarrier SC3, and the fourth merged stream is allocated to a fourth subcarrier SC4.

In other embodiments, each input data unit consists of four 8-bit DP-16QAM words. In some such embodiments, the merging consists of merging two streams A and B. In other such embodiments, the inputting comprises inputting four input streams A, B, C, and D, and the merging comprises merging the four input streams A, B, C, and D.

In other embodiments, each input data unit consists of one 4-bit DP-QPSK word. In some such embodiments, the merging consists of merging two streams A and B. In other such embodiments, the inputting comprises inputting four input streams A, B, C, and D, and the merging comprises merging the four input streams A, B, C, and D.

In some embodiments, in the producing of each of the output data units, the merging of input data units assigned to a given merged stream maintains sequential order and contiguity of encoded data blocks within each of the merged input data units.

In some embodiments, each of the input streams of sequentially ordered input data units is generated by interleaving output streams from a respective pair of OFEC encoders.

In another aspect, the present disclosure relates to an apparatus comprising means for performing the method according to the first aspect.

In another aspect, the present disclosure relates to apparatus comprising a merging circuit and an allocating circuit. The merging circuit is configured to input at least an input stream A and an input stream B of sequentially ordered input data units of data encoded by a plurality of OFEC encoders, and to merge the said at least streams A and B so as to produce at least a first merged stream and a second merged stream of sequentially ordered output data units. The allocating circuit is configured to allocate one merged stream to an optical subcarrier SC0 of an optical communication system and to allocate another merged stream to an optical subcarrier SC1 of an optical communication system having two polarization channels. The optical subcarriers SC0 and SC1 belong to a plurality of at least two optical subcarriers. Each of the input data units comprises one or more blocks of encoded data.

The merging circuit is configured to assign input data units from the respective input streams to the respective merged streams by round robin distribution, and is further configured, for each respective merged stream, to generate output data units by merging input data units assigned to that merged stream, such that each output data unit for that merged stream comprises the encoded data blocks of one input data unit from each of the respective input streams.

The allocating circuit is configured to periodically alternate the allocating of merged streams between a first allocation scheme in which the first merged stream is allocated to SC0 and the second merged stream is allocated to SC1, and a second allocation scheme in which the first merged stream is allocated to SC1 and the second merged stream is allocated to SC0, whereby for each OFEC encoder of said OFEC encoder plurality, a same number of bits is allocated to each subcarrier of the subcarrier plurality, and a same number of bits is allocated to each of the two polarization channels.

In embodiments, each input data unit is an 8-bit DP-16QAM word, there are four input streams A, B, C, and D of sequentially ordered input data units; and streams A, B, C, and D are merged so as to produce a first merged stream and a second merged stream of sequentially ordered output data units.

In embodiments, each input data unit consists of two 8-bit DP-16QAM words, there are four input streams A, B, C, and D of sequentially ordered input data units, and streams A, B, C, and D are merged so as to produce first, second, third, and fourth merged streams of sequentially ordered output data units. In the first allocation scheme, the first merged stream is allocated to SC0, the second merged stream is allocated to SC1, the third merged stream is allocated to a third subcarrier SC2 of the subcarrier plurality, and the fourth merged stream is allocated to a fourth subcarrier SC3 of the subcarrier plurality. In the second allocation scheme, the first merged stream is allocated to SC1, the second merged stream is allocated to SC0, the third merged stream is allocated to a third subcarrier SC3, and the fourth merged stream is allocated to a fourth subcarrier SC4.

In another aspect, the present disclosure relates to apparatus comprising a merging circuit and an allocating circuit. The merging circuit is configured to input at least an input stream A and an input stream B of sequentially ordered input data units of data encoded by a plurality of OFEC encoders, and to merge the said at least streams A and B so as to produce at least a first merged stream and a second merged stream of sequentially ordered output data units. The allocating circuit is configured to allocate one merged stream to an optical subcarrier SC0 of an optical communication system and to allocate another merged stream to an optical subcarrier SC1 of an optical communication system having two polarization channels. The optical subcarriers SC0 and SC1 belong to a plurality of at least two optical subcarriers. Each of the input data units comprises one or more blocks of encoded data;

The merging circuit is configured to assign input data units from the respective input streams to the respective merged streams by round robin distribution, and is further configured, for each respective merged stream, to generate output data units by merging input data units assigned to that merged stream, such that each output data unit for that merged stream comprises the encoded data blocks of one input data unit from each of the respective input streams.

Each input data unit consists of four 8-bit DP-16QAM words, whereby for each OFEC encoder of said OFEC encoder plurality, a same number of bits is allocated to each subcarrier of the subcarrier plurality, and a same number of bits is allocated to each of the two polarization channels.

In another aspect, the present disclosure relates to apparatus comprising a merging circuit and an allocating circuit. The merging circuit is configured to input at least an input stream A and an input stream B of sequentially ordered input data units of data encoded by a plurality of OFEC encoders, and to merge the said at least streams A and B so as to produce at least a first merged stream and a second merged stream of sequentially ordered output data units. The allocating circuit is configured to allocate one merged stream to an optical subcarrier SC0 of an optical communication system and to allocate another merged stream to an optical subcarrier SC1 of an optical communication system having two polarization channels. The optical subcarriers SC0 and SC1 belong to a plurality of at least two optical subcarriers. Each of the input data units comprises one or more blocks of encoded data;

The merging circuit is configured to assign input data units from the respective input streams to the respective merged streams by round robin distribution, and is further configured, for each respective merged stream, to generate output data units by merging input data units assigned to that merged stream, such that each output data unit for that merged stream comprises the encoded data blocks of one input data unit from each of the respective input streams.

Each input data unit consists of one 4-bit DP-QPSK word, whereby for each OFEC encoder of said OFEC encoder plurality, a same number of bits is allocated to each subcarrier of the subcarrier plurality, and a same number of bits is allocated to each of the two polarization channels.

In further embodiments, the inputting comprises inputting four input streams A, B, C, and D, and the merging comprises merging the four input streams A, B, C, and D.

### Definitions

The quantity "200G" or "200 Gigabits per second" or "200Gb/s", as used herein to describe a data rate or the like, means a speed for the transmission of data within or between devices that supports transmission at 200 Gigabits per second and is within established tolerances for compliance with standards for 200G communication. In practice, 200G transmission may be transmission at 200 Gigabits per second, or transmission at a modestly higher speed to accommodate coding redundancy and other overhead.

The quantity "800G" or "800 Gigabits per second" or "800Gb/s", as used herein to describe a data rate or the like, means a speed for the transmission of data within or between devices that supports transmission at 800 Gigabits per second and is within established tolerances for compliance with standards for 800G communication. In practice, 800G transmission may be transmission at 800 Gigabits per second, or transmission at a modestly higher speed to accommodate coding redundancy and other overhead.

The quantities "1600G", "1600 Gigabits per second", "1600Gb/s", or "1.6T" as used herein to describe a data rate or the like, means a speed for the transmission of data within or between devices that supports transmission at 1600 Gigabits per second and is within established tolerances for compliance with standards for 1600G communication. In practice, 1600G transmission may be transmission at 1600 Gigabits per second, or transmission at a modestly higher speed to accommodate coding redundancy and other overhead.

Other quantities used herein to describe a data rate or the like, likewise mean a speed for the transmission of data within or between devices that supports transmission at the stated rate.

### Brief Description of the Drawings

FIG. 1 is a highly simplified block diagram of a typical coherent optical transceiver.
FIG. 2 is a schematic diagram of an OFEC encoder memory organized as a matrix of 16×16 blocks of bits arranged in rows and columns.
FIG. 3 is a block diagram illustrating OFEC encoding steps including interleaving.
FIG. 4 is a block diagram that further illustrates OFEC interleaving.
FIG. 5 shows a known method that may be used in a 1.6T transmitter for distributing the outputs of eight parallel OFEC encoders into two parallel lanes for modulation onto respective optical subcarriers. The figure is based on standards proposal oif2024.540.00.
FIG. 6 shows a known method that may be used in a 1.6T transmitter for distributing the outputs of four parallel OFEC encoders into two parallel lanes for modulation onto respective optical subcarriers. Like FIG. 5, FIG. 6 is based on standards proposal oif2024.540.00.
FIG. 7 is a diagram of an encoded block of 8 bits corresponding to a DP-16QAM symbol.
FIG. 8 is a graphical representation of how bits may be assigned within a 16×16 bit square code block.
FIG. 9 is a graphical diagram illustrating a tracing of 16×16 bit square code blocks through a simulated communication link using the approach shown in FIG. 5, to determine which bits of the 16×16 bit blocks were assigned to which of two subcarriers.
FIG. 10 is a graphical diagram illustrating a tracing of 16×16 bit square code blocks through a communication link using the approach shown in FIG. 6, to determine which of bits of the 16×16 bit blocks were assigned to which of two subcarriers.
FIGS. 11-13 are block diagrams illustrating examples of how subcarriers may be allocated according to principles described here, in a system in which the transmitter side has four encoders and two interleavers receiving output from respective pairs of the encoders, and in which the encoded data is mapped to DP-16QAM symbols for transmission on two subcarriers.
FIGS. 14 and 15 are block diagrams illustrating examples of how subcarriers may be allocated according to principles described here, in a system in which the transmitter side has eight encoders and four interleavers receiving output from respective pairs of the encoders, and in which the encoded data is mapped to DP-16QAM symbols for transmission on two subcarriers.
FIG. 16 is a block diagram illustrating an example of how subcarriers may be allocated according to principles described here, in a system in which the transmitter side has four encoders and two interleavers receiving output from respective pairs of the encoders, and the encoded data is mapped to DP-QPSK symbols for transmission on two subcarriers.
FIG. 17 is a block diagram illustrating an example of how subcarriers may be allocated according to principles described here, in a system in which the transmitter side has eight encoders and four interleavers receiving output from respective pairs of the encoders, and in which the encoded data is mapped to DP-QPSK symbols for transmission on two subcarriers.
FIG. 18 is a block diagram illustrating an example of how subcarriers may be allocated according to principles described here, in a system in which the transmitter side has eight encoders and four interleavers receiving output from respective pairs of the encoders, and in which the encoded data is mapped to DP-16QAM symbols for transmission on four subcarriers.
FIGS. 19-26 are graphical diagrams illustrating tracings of 16×16 bit square code blocks through a communication link to determine which of bits of the 16×16 bit blocks were assigned to which subcarriers. FIGS. 19-26 show the results of using the approaches of FIGS. 11-18, respectively.

### Detailed Description

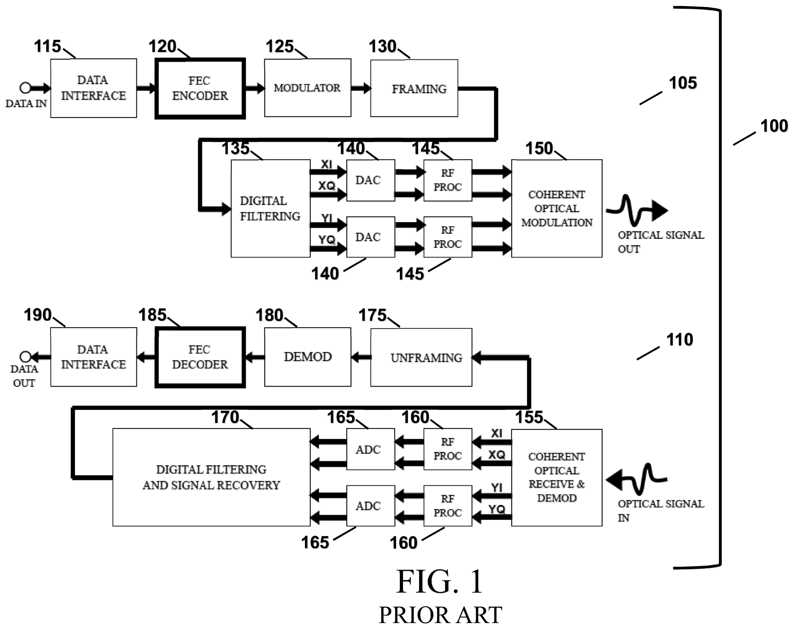

FIG. 1 is a highly simplified block diagram of a typical optical coherent transceiver **100,** provided here for pedagogical purposes and not meant to be limiting as to the processing steps or as to the mode or means of their performance. The transceiver includes a transmitter side **105** and a receiver side **110.**

At transmitter side **105,** the bitstream representing the initial data passes, as shown, through data interface **115,** OFEC encoder **120,** modulator **125,** and framer **130.** The framer output is subjected to digital filtering **135.** As shown in the figure, the digitally filtered output may have two polarization channels X and Y, and each polarization channel may have an in-phase component I and a quadrature component Q. The digitally filtered output undergoes digital-to-analog conversion **140,** and the resulting analog signal undergoes radiofrequency processing **145** and at block **150** is used to modulate the analog signal onto one or more optical carriers to produce an optical signal that is then transmitted.

The processes described above for OFEC encoding would typically be carried out at block **120** of the figure, labeled "FEC Encoder".

At receiver side **110,** the incoming optical signal undergoes coherent optical detection and demodulation **155.** As shown in the figure, the optically demodulated output may have two polarization channels X and Y, and each polarization channel may have an in-phase component I and a quadrature component Q. The optically demodulated signal undergoes RF processing **160,** analog-to-digital conversion **165,** and digital filtering and signal recovery **170.** The digitally filtered signal then passes through unframer **175,** demodulator **180,** OFEC decoder **185,** and data interface **190** to produce the output, which is the received data signal.

The processes described above for OFEC decoding would typically be carried out at block **185** of the figure, labeled "FEC Decoder".

It should be noted that it would be typical, at both the transmitter side and the receiver side, for each of the respective signal branches XI, XQ, YI, and YQ to have its own respective RF processing circuitry and its own respective ADC or DAC circuitry. For simplicity of presentation, some of these circuits have been combined in FIG. 1.

The circuitry for carrying out the OFEC encoding and decoding operations would typically be constituted by special-purpose, high-speed, integrated circuits. Other possibilities, which are also within the scope of the present disclosure, include special and general purpose digital signal processors and general purpose computers suitably programmed and operating under software control.

The input to an OFEC coder, according to current standards, is processed as a set of 84 coder blocks of 14,208 bits each. For each block, these bits are distributed at single-bit granularity to four parallel OFEC encoders in round-robin fashion. By "round-robin fashion" is meant that the respective destinations, in this instance the OFEC encoders, are placed in sequential order, and the bits are assigned sequentially, one bit to each destination, returning to the first destination after the last destination has received its bit.

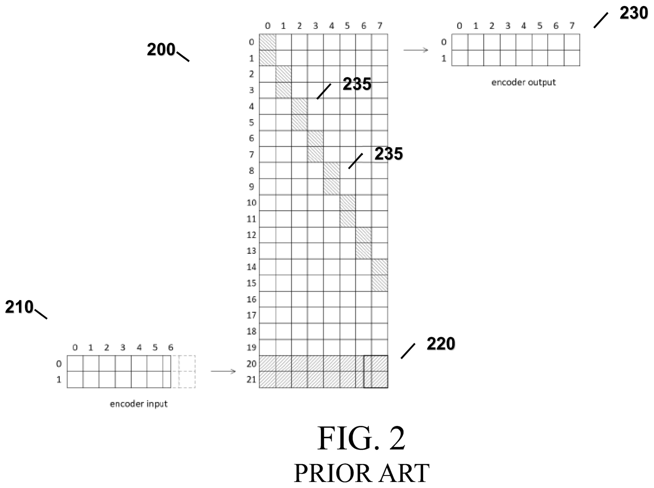

As shown in FIG. 2, the encoder memory is organized as a matrix **200** of 22×8 blocks of 16×16 bits each, arranged in rows and columns. Encoding is done sequentially in order of increasing row index. In every encoding step, the OFEC encoder takes, as input **210,** 32×111 =3552 bits. These are placed in memory. Then, a Bose-Chaudhuri-Hocquenghem (BCH) coding algorithm is implemented to compute 32×17 redundant parity bits **220.** The computed parity bits are placed in memory, and two rows of the memory, each containing eight 16×16 bit blocks, are pushed out as 32×128=4096 output bits of an OFEC encoder output block 230 of the OFEC encoder. The shaded blocks **235** in the figure represent bits previously entered into the memory that are used in the computation of the redundant parity bits.

At the receiver, the decoding is an iterative process that proceeds through several decoding stages. Each decoding stage refines the results of the preceding stage so that more errors are corrected. The decoder memory is not shown explicitly in the drawings. However, it is notable that at each decoding stage, the decoder memory is defined, in substance, as a mirror image of the encoder memory **200.**

For each bit in the transmitter, there is a corresponding log-likelihood ratio ("LLR") on the receiver side. The initial LLRs are typically produced at the receiver by a demapper. As the decoding progresses through successive stages, the LLRs may change in value, with some values possibly changing sign, and some values possibly changing in amplitude.

At the receiver, the LLRs are pushed in blocks **320** of 32×128 = 4096 through the decoder memory. At each decoding stage, the LLRs are updated and written back into memory.

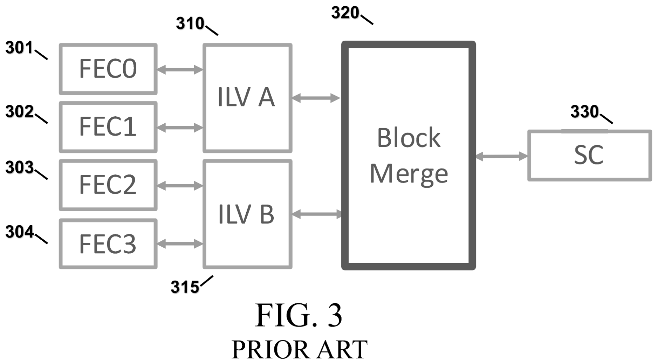

FIG. 3, reading from left to right, illustrates further processing steps that, pedagogically, may be considered as part of the processing within FEC encoder block **120** of FIG. 1.

Double-headed arrows representing the direction of process flow are used in FIG. 3 and in subsequent figures to indicate that receiver-side processing conceptually follows the same steps when the figure is read from right to left, with each function replaced by its inverse function.

As shown in FIG. 3, the outputs of OFEC encoders **301-304,** also respectively labeled in the figure as encoders FEC0-FEC4, are interleaved to improve the burst tolerance of the code. Interleaving is performed in an intra-block stage, followed by an inter-block stage.

For intra-block interleaving, which is not shown explicitly in FIG. 3, a permutation is applied to each 16×16 bit square block in the interleaver buffer as it comes in from the encoder. For inter-block interleaving, the interleaver buffer is partitioned into two functional entities **310, 315,** respectively referred to here as interleaver (ILV) A and interleaver (ILV) B. Each of interleavers **310** and **315** processes the output from a respective pair of OFEC encoders, namely, encoders **301** and **302,** and encoders **303** and **304,** respectively. Each of the interleavers interleaves the outputs from its respective encoder pair at a granularity of 8 bits. At block **320,** the outputs from interleavers **310** and **315** are combined into a single stream by round-robin merging and subjected to further processing, which may include symbol mapping, polarization distribution, and optical modulation **330** onto an optical subcarrier.

Because of the symmetry between the transmitter and receiver sides of a typical coherent optical transceiver, FIG. 3, read from right to left, illustrates processing steps that, *mutatis mutandis,* may pedagogically be considered as part of the processing within FEC decoder block **185** of FIG. 1.

It should be noted, in regard to FIG. 3 and the associated discussion, that there are both similarities and differences between the OIF 800ZR standard and the OpenROADM MSA 6.0 800G standard. Both standards call for four OFEC coders and decoders, a single optical carrier, and two inter-block interleavers.

Under OIF 800ZR, bits are mapped to uniform 16QAM symbols without shaping, and interleaver output is combined at block **320** in 8-bit blocks by round robin merging.

Under OpenROADM MSA 6.0 800G, bits may be mapped to uniform 16QAM symbols, to uniform QPSK symbols, or to shaped 16QAM symbols. The interleaver output is combined at block **320** by round-robin merging of 8-bit blocks for 16QAM, or of 4-bit blocks for QPSK.

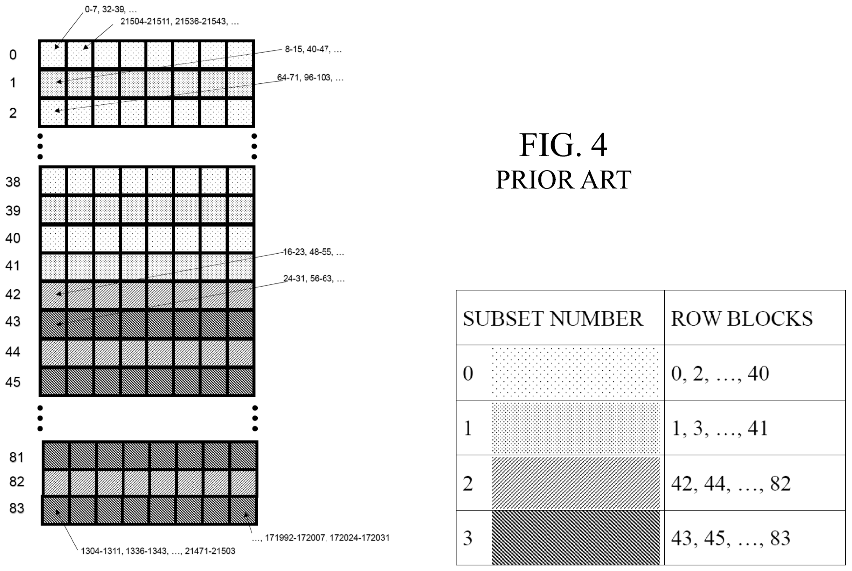

The inter-block interleaver algorithm currently favored for optical transmission systems using OFEC coding, referred to here as the "OFEC interleaver", is well known in the art and need not be described here in detail. For clarity, a brief description of the OFEC interleaver is presented below, with reference to FIG. 4. FIG. 4 and the associated description have been adapted from the OIF 800ZR Implementation Agreement.

For inter-block interleaving between the outputs of two OFEC encoders, here denominated "ENC0" and "ENC1", the 16×16 bit output blocks of the respective encoders are written row-by-row into the interleaver buffer, retaining their 16×16 structure. With reference to FIG. 4, it is noted that the 16×16 bit output blocks in subsets 0 and 2 come from ENC0, and the 16×16 bit output blocks in subsets 1 and 3 come from ENC1.

As noted, the interleaver buffer is partitioned between ENC0 and ENC1. As shown in FIG. 4, the interleaver buffer is further partitioned to an upper half of 42 block rows corresponding to subsets 0 and 1, and to a lower half of 42 block rows, corresponding to subsets 2 and 3. The result is to partition the buffer into the four subsets 0-3 shown in the figure, each containing 21×8 square blocks, or 336×128 bits.

On output, groups of 8 bits are taken in turn from each subset, reading them out of a column of bits before proceeding to the next columns of bits. As shown in FIG. 4, the first 8 bits are read from the top of first column of subset 0, then the first 8 bits from the first column of subsets 1, 2 and 3. Those 32 bits are then followed by taking the next 8 bits in the first column of each of the subsets 0, 1, 2 and 3. After 42 such cycles of 4×8 bits each, the first bit column of the interleaver buffer will be completely read out, and the output process continues by reading bit columns 1 to 127.

The bits read out of the interleavers are merged as shown, for example, at block **320** of FIG. 3. The merged interleaver output is passed to the modulator, where, for example, the output bits may be mapped in groups of 8 bits to Dual Polarization (DP) 16QAM symbols.

In DP-16QAM mapping, 8 bits from interleaver A are mapped to a DP-16QAM symbol, followed by mapping of 8 bits from interleaver B to a DP-16QAM symbol, and so on. The OFEC Coder Block output after interleaving consists of 1,376,256 bits, which may be mapped, for example, to a group of 172,032 DP-16QAM symbols.

We are not aware, at present, of proposals to use DP-QPSK symbols for 1.6T transmission. For transmission and reception at the lower rate of 400 Gbps, however, the OpenROADM 6.0 standard provides for the use of both 16QAM and QPSK modes. In OpenROADM 6.0, four OFEC coders and decoders may be used, with two OFEC interleavers and de-interleavers. The outputs of the interleavers are taken in blocks of 4 bits, each block corresponding to a DP-QPSK symbol, taken alternately from the first and from the second interleaver.

As explained above, there is interest in extending the capabilities of optical modems to 1.6T, i.e., transmission and reception at 1600 Gigabit per second. An example of a proposed 1.6T standard is the 1600ZR+ implementation agreement from the Open Internet Forum (OIF). A coherent optical transceiver compliant with 1600ZR+ uses eight OFEC encoders and decoders, maps to DP-16QAM symbols with the capability for constellation shaping, and transmits on two subcarriers.

For ease of implementation and for backward compatibility, it is desirable to minimize the changes from the 800G standards to the standards for 1.6T. One feature of both OIF 800ZR and OpenROADM MSA 6.0 800G that it would be advantageous to retain is that at the OFEC encoder output (and correspondingly, at the OFEC decoder input), all 16×16 square code blocks have identical structure in the distribution pattern of sign and amplitude bits. Another such feature is that all 16×16 square code blocks have identical structure in the distribution pattern of assigned X or Y polarization channels. Yet another such feature is that the code bits of the four OFEC encoders are well interleaved before modulation, with the consequence that error bursts on the single-carrier transmission channel are evenly distributed across the four OFEC decoders.

We have found a vulnerability in the OFEC interleaver and corresponding de-interleaver that can lead to sub-optimal performance of 1.6T systems with two subcarriers, at least when the number of OFEC encoders and decoders is 4 or 8 and the symbol mapping is DP-16QAM. More specifically, we performed simulations in which the 16×16 square code blocks were tracked to determine the particular subcarrier over which each block was transmitted. We found that, depending on the merging algorithm that combines the outputs from the respective interleavers, the OFEC inter-block interleaver can interact with the merging process in such a way that the code bits of the respective OFEC encoders are not well distributed between the two subcarriers.

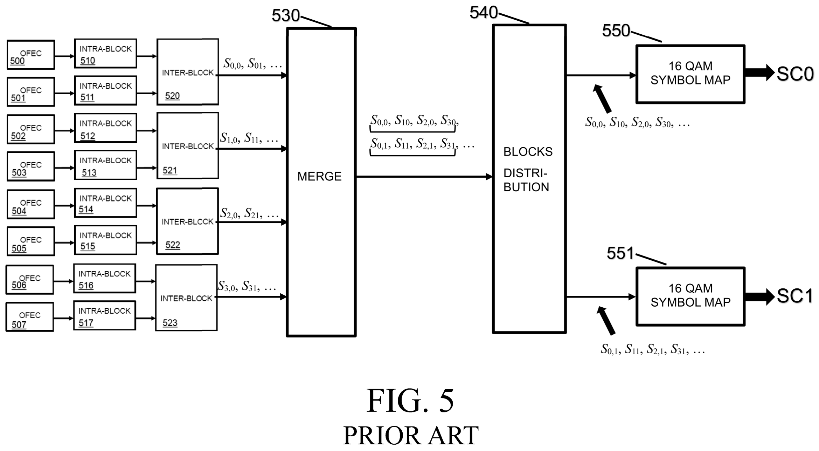

FIG. 5 shows a known method that may be used in a 1.6T transmitter for distributing the outputs of eight parallel OFEC encoders into two parallel lanes for mapping to DP-16QAM symbols and modulation onto respective optical subcarriers. The figure is based on standards proposal oif2024.540.00.

As shown in the figure, after intra-block interleaving, each of four inter-block interleavers combines the outputs of a respective pair of the OFEC encoders. At the functional block labeled "Merge" in the figure, the outputs of the four respective inter-block interleavers are combined in round-robin fashion, at a granularity of 8 bits, to produce a single stream of 8-bit blocks. That is, numbering the inter-block interleavers from 0 to 3, their respective outputs may be designated (*s*_{0,0},*s*_{0,1}, ...), (*s*_{1,0},*s*_{1,1}, ...), (*s*_{2,0},*s*_{2,1}, ...) and (*s*_{3,0},*s*_{3,1}, ...), respectively, wherein each of the symbols *s*ᵢⱼ represents an 8-bit block. After the round-robin merge, the resulting output stream has the form, *S*= (*s*_{0,0},*s*_{1,0},*s*_{2,0},*s*_{3,0},*s*_{0,1}, *s*_{1,1},*s*_{2,1},*s*_{3,1}, ...).

At the functional block labeled "Blocks Distribution", the stream S is distributed alternately between subcarrier 0 and subcarrier 1 with a granularity of four 8-bit blocks. That is, the blocks are distributed according to Table 1:

| **Table 1** | |
|---|---|
| Sequence of four 8-bit blocks | Assigned subcarrier |
| *s*_{0,0},*s*_{1,0},*s*_{2,0},*s*_{3,0} | SC0 |
| *s*_{0,1},*s*_{1,1},*s*_{2,1},*s*_{3,1} | SC1 |
| *s*_{0,2},*s*_{1,02},*s*_{2,2},*s*_{3,2} | SC0 |
| *s*_{0,3},*s*_{1,3},*s*_{2,3},*s*_{3,3} | SC1 |
| | ⋮ |

The overall effect of this distribution method is to pull the first 8-bit block from each inter-block interleaver and assign the pulled blocks, in sequential order, to SC0; then pull the second 8-bit block from each inter-block interleaver and assign the pulled blocks, in sequential order to SC1; then return for another cycle, etc. Stated differently, let the 8-bit blocks output from the first interleaver be designated A0, A1, etc., let the 8-bit blocks output from the second interleaver be designated B0, B1, etc., and similarly, C0, C1, etc. and D0, D1, etc. for the third and fourth interleavers, respectively. Then the sequence A0, B0, C0, D0, A2, B2, C2, D2, ... is assigned to subcarrier 0, and the sequence A1, B1, C1, D1, A3, B3, C3, D3, ..., is assigned to subcarrier 1.

When we analyzed this distribution method, we found that, due to the combined effect of the inter-block interleaving, the merging, and the block distribution, the code bits that were output by the OFEC encoders were not well distributed across the two subcarriers. Instead, output bits from the even-numbered encoders OFEC0, OFEC2, OFEC4, and OFEC6 were transmitted only over SC0, and output bits from the odd-numbered encoders OFEC1, OFEC3, OFEC5, and OFEC7 were transmitted only over SC1.

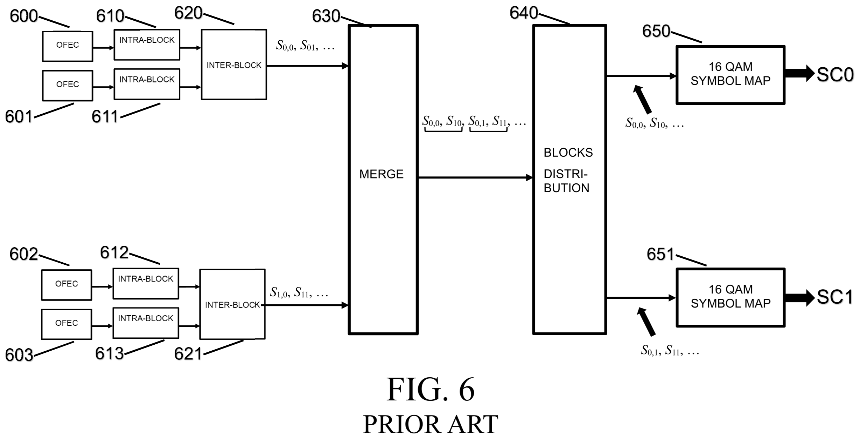

FIG. 6 shows a known method that may be used in a 1.6T transmitter for distributing the outputs of four parallel OFEC encoders into two parallel lanes for mapping to DP-16QAM symbols and modulation onto respective optical subcarriers. Like FIG. 5, FIG. 6 is based on standards proposal oif2024.540.00.

As shown in the figure, after intra-block interleaving, each of two inter-block interleavers combines the outputs of a respective pair of the OFEC encoders. At the functional block labeled "Merge" in the figure, the outputs of the two respective inter-block interleavers are combined in round-robin fashion, at a granularity of 8 bits, to produce a single stream of 8-bit blocks. That is, numbering the inter-block interleavers from 0 to 1, their respective outputs may be designated (*s*_{0,0},*s*_{0,1}, ...), (*s*_{1,0},*s*_{1,1}, ...), respectively, wherein each of the symbols *s*ᵢⱼ represents an 8-bit block. After the round-robin merge, the resulting output stream has the form, S= (*s*_{0,0},*s*_{1,0},*s*_{0,1}, *s*_{1,1}, ...).

At the functional block labeled "Blocks Distribution", the stream S is distributed alternately between subcarrier 0 and subcarrier 1 with a granularity of two 8-bit blocks. That is, the blocks are distributed according to Table 2:

| **Table 2** | |
|---|---|
| Sequence of two 8-bit blocks | Assigned subcarrier |
| *s*_{0,0},*s*_{1,0} | SC0 |
| *s*_{0,1},*s*_{1,1} | SC1 |
| *s*_{0,2},*s*_{1,2} | SC0 |
| *s*_{0,3},*s*_{1,3} | SC1 |
| | ⋮ |

The overall effect of this distribution method is to pull the first 8-bit block from each inter-block interleaver and assign the pulled blocks, in sequential order, to SC0; then pull the second 8-bit block from each inter-block interleaver and assign the pulled blocks, in sequential order to SC1; then return for another cycle, etc.

Stated differently, let the 8-bit blocks output from the first interleaver be designated A0, A1, etc., and let the 8-bit blocks output from the second interleaver be designated B0, B1, etc. Then the sequence A0, B0, A2, B2, ... is assigned to subcarrier 0, and the sequence A1, B1, A3, B3, ... is assigned to subcarrier 1.

When we analyzed this distribution method, we found that, due to the combined effect of the inter-block interleaving, the merging, and the block distribution, the code bits that were input to the OFEC encoders were not well distributed across the two subcarriers. Instead, input bits destined for the even-numbered encoders OFEC0 and OFEC2 were transmitted only over SC0, and input bits destined for the odd-numbered encoders OFEC1 and OFEC3 were transmitted only over SC1.

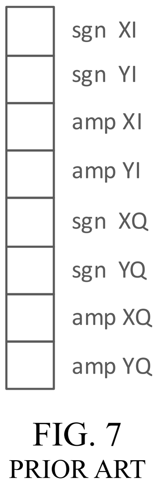

The behavior described above is better understood with reference to FIGS. 7-10 and the following discussion.

FIG. 7 is a diagram of an 8-bit block corresponding to a DP-16QAM symbol; that is, the eight bits of the block shown in FIG. 7 will map to one 8-bit DP-16QAM symbol. For clarity, we note that the 8-bit block of FIG. 7 is not the direct result of OFEC encoding, but rather has, after OFEC encoding, been subjected to intra-block interleaving. However, it should be noted that, as the inter-block interleaver operates on such 8-bit blocks, it leaves the internal structure of these 8-bit blocks intact.

The bits collectively represent a symbol having in-phase ("I") and quadrature ("Q") components and orthogonal polarization components X and Y. Individually, the bits represent the sign of the I component in the X and Y polarizations channels, respectively; the amplitude of the I component in the respective X and Y channels; the sign of the Q component in the respective X and Y channels; and the amplitude of the Q component in the respective X and Y channels.

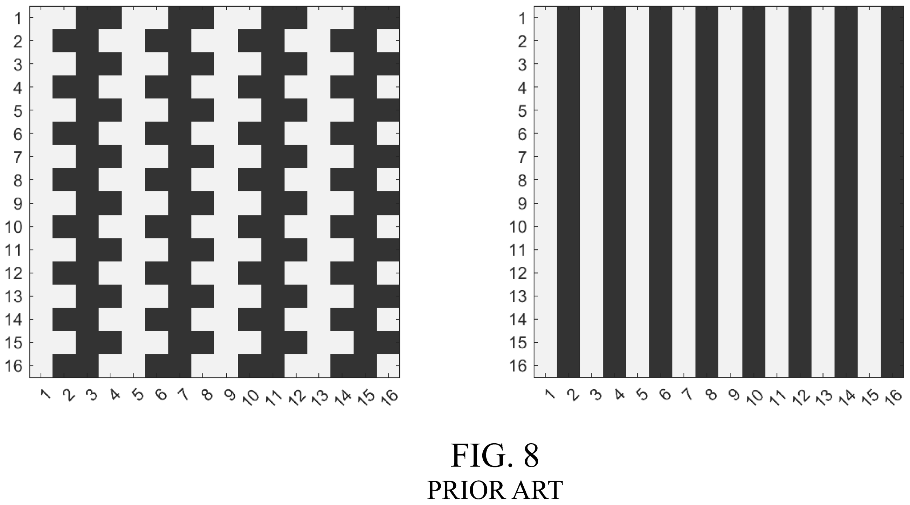

A 16×16 bit square code block may contain, for example, the bits for thirty-two DP-16QAM symbols. FIG. 8 is a graphical representation of how the bits are assigned within a 16×16 bit square code block. The left-hand image in the figure shows the sign bits in white and the amplitude bits in black, but does not discriminate between bits assigned to the X polarization channel and bits assigned to the Y polarization channel. The polarization assignments are shown by the right-hand image in the figure, where white represents X polarization and black represents Y polarization.

By way of example, the bit assignments shown in FIG. 8 are described, for modulation onto a *single* carrier, in the OIF 800ZR and 1600ZR Implementation Agreements and the OpenROADM 6.0 Multi-Source Agreement. For systems with four FEC encoders and decoders, as described, e.g., in OIF 800ZR and OpenROADM 6.0, the bit assignment scheme of FIG. 8 has several notable properties: At the FEC encoder output (as well as the decoder input), all 16×16 blocks have the same structure relative to the sign and amplitude bits, and the same structure relative to the assignments to polarization channels. Moreover, the code bits of the four FEC encoders are well interleaved before modulation. This is advantageous because, on average, it results in the even distribution of error bursts on the transmission channel across the four FEC decoders.

As explained above with reference to FIG. 5, the overall effect of the distribution method shown there is to pull the first 8-bit block from each of eight inter-block interleavers and assign the pulled blocks, in sequential order, to SC0; then pull the second 8-bit block from each inter-block interleaver and assign the pulled blocks, in sequential order to SC1; then return for another cycle, etc. In other words, using the same designations discussed above, the sequence A0, B0, C0, D0, A2, B2, C2, D2, ... is assigned to subcarrier 0, and the sequence A1, B1, C1, D1, A3, B3, C3, D3, ..., is assigned to subcarrier 1.

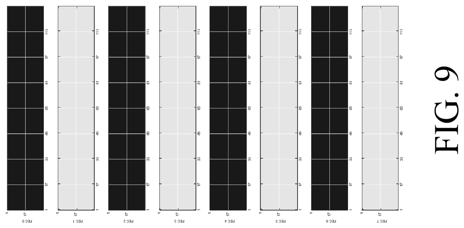

With reference to FIG. 2, above, we explained that in each encoding step, two rows of the encoder memory, each containing eight 16×16 bit blocks, are pushed out as 32×128=4096 output bits of an OFEC encoder output block 230 of the FEC encoder. By simulation, we traced the bits of the 16×16 bit square code blocks of several OFEC encoder output blocks per OFEC encoder through a communication link using the approach shown in FIG. 5, to determine which bits of the 16×16 bit blocks were assigned to which subcarriers. The result is shown in FIG. 9.

It should be noted, in regard to the traced bits, that each bit assigned to a transmitted and received symbol belongs to one of eight classes, defined by whether it is a sign or amplitude bit, whether it is designated for X or Y polarization, and whether it is designated for the subcarrier S0 or the subcarrier S1.

Eight OFEC encoder output blocks are shown in FIG. 9. Each of the eight blocks is output from a respective one of the eight FEC encoders. The bits within the code blocks are colored according to the subcarrier to which they are assigned. Bits assigned to SC0 are colored black, and bits assigned to SC1 are colored white. It will be evident from the figure that bits of encoders 0, 2, 4, and 6 are transmitted only over SC0, and bits of encoders 1, 3, 5, and 7 are transmitted only over SC1. As a consequence, the overall performance of the communication link is limited by the weaker of the two subcarriers.

As explained above with reference to FIG. 6, the overall effect of the distribution method shown there is to pull the first 8-bit block from each of four inter-block interleavers and assign the pulled blocks, in sequential order, to SC0; then pull the second 8-bit block from each inter-block interleaver and assign the pulled blocks, in sequential order to SC1; then return for another cycle, etc. In other words, using the same designations discussed above, the sequence A0, B0, A2, B2, ... is assigned to subcarrier 0, and the sequence A1, B1, A3, B3, ..., is assigned to subcarrier 1.

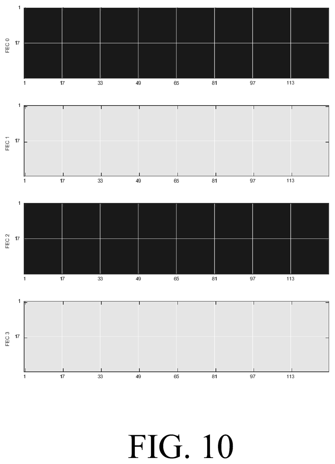

By simulation, we traced the bits of the 16×16 bit square code blocks through a communication link using the approach shown in FIG. 6, to determine which of the bits of the 16×16 bit blocks were assigned to which subcarriers. The result is shown in FIG. 10.

Four OFEC encoder output blocks are shown in FIG. 10. Each of the four blocks is output from a respective one of the four FEC encoders. Each bit of the constituent 16×16 bit square code blocks is colored according to the subcarrier to which it is assigned. Bits assigned to SC0 are colored black, and bits assigned to SC1 are colored white. It will be evident from the figure that bits of encoders 0, and 2 are transmitted only over SC0, and bits of encoders land 3 are transmitted only over SC1. As a consequence, the overall performance of the communication link is limited by the weaker of the two subcarriers.

The uneven distribution of bits over subcarriers that we observed for the eight-encoder and four-encoder methods described above is disadvantageous, because it can make the transmission system more vulnerable to burst errors, as well as to imbalance in the signal-to-noise ratio (SNR) between the respective subcarriers and between the X and Y polarization channels of each subcarrier. To mitigate this problem, we have devised new distribution methods that achieve a more uniform distribution of bits over subcarriers. In respective embodiments, our new approach is applicable, at least, to dual subcarrier systems that combine four or eight encoders with 16QAM or QPSK symbol mapping, as well as to four-subcarrier systems with eight encoders and 16QAM symbol mapping. Our approach is compatible with both uniform signaling and constellation shaping. Relative to the 800G standards discussed above, it substantially changes only the block merge for assignment of bits between the respective lanes for encoders and interleavers and the mappers to the subcarriers.

An important feature of our new approach, when applied to dual subcarrier transmission with either four or eight OFEC encoders, is that the bits of each BCH half codeword are distributed such that ¼ are transmitted over the X polarization channel of SC0, ¼ are transmitted over the Y polarization channel of SC0, ¼ are transmitted over the X polarization channel of SC1, and ¼ are transmitted over the Y polarization channel of SC1. By "BCH half codeword" is here meant one row of the 32 rows of a 4096-bit OFEC encoder output block.

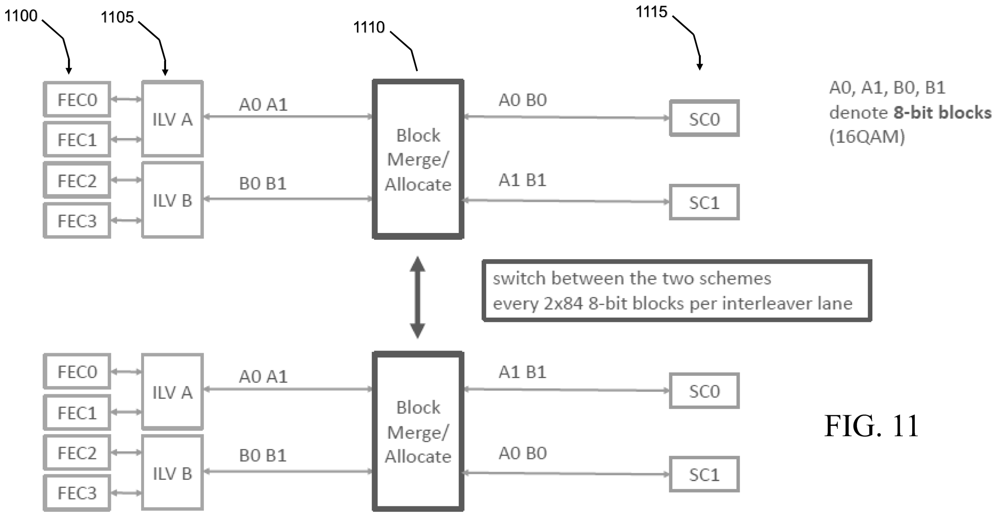

Several embodiments of our new approach relate to systems in which the transmitter side has four encoders and two interleavers receiving output from respective pairs of the encoders, and the encoded data is mapped to DP-16QAM symbols for transmission on two subcarriers. Examples of such embodiments are provided in FIGS. 11, 12, and 13.

In each of FIGS. 11-13, the OFEC encoder functional blocks are collectively called out by the reference numeral **1100,** the interleaver functional blocks are collectively called out by the reference numeral **1105,** the functional block representing the operations of merging and allocating blocks of bits to subcarriers is called out by the reference numeral **1110,** and the subcarrier lanes are collectively called out by the reference numeral **1115.**

In FIGS. 11-13, the interleavers are labeled A and B. The sequences of 8-bit blocks, i.e., words of DP-16QAM, output from each interleaver are respectively designated A0, A1, etc., and B0, B1, etc.

In the example of FIG. 11, there are two alternating schemes for allocating 8-bit blocks to subcarriers. The first scheme is a cycle in which the 16 bits A0B0 go to SC0, the 16 bits A1B1 go to SC1, and the cycle repeats. The second scheme is a cycle in which the subcarrier lanes exchange position. That is, the 16 bits A1B1 go to SC0, the 16 bits A0B0 go to SC1, and the cycle repeats. The process switches between the two schemes whenever 2×84 8-bit blocks in each interleaver lane have been allocated.

In each cycle, the process effectively takes the first 8-bit block from each interleaver and allocates the blocks to one subcarrier, and takes the second 8-bit block from each interleaver and allocates the blocks to the other subcarrier, with the additional feature that the destination subcarriers are periodically interchanged.

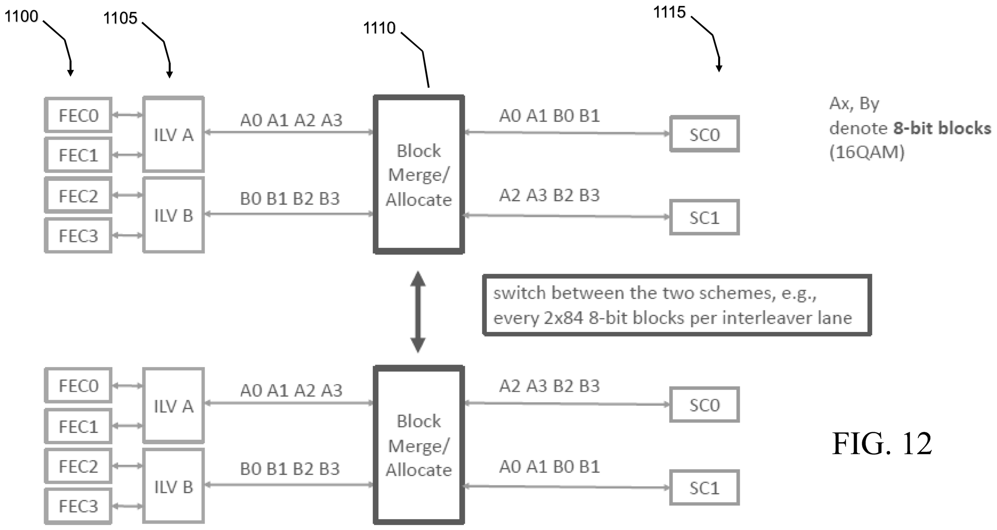

In the example of FIG. 12, there are two alternating schemes for allocating 8-bit blocks to subcarriers. The first scheme is a cycle in which the 32 bits A0A1B0B1 go to SC0, the 32 bits A2A3B2B3 go to SC1, and the cycle repeats. The second scheme is a cycle in which the subcarrier lanes exchange position. That is, the 32 bits A2A3B2B3 go to SC0, the 32 bits A0A1B0B1 go to SC1, and the cycle repeats. The process switches between the two schemes whenever 2×84 8-bit blocks in each interleaver lane have been allocated.

In each cycle, the process effectively takes the first two 8-bit blocks from each interleaver and allocates the blocks to one subcarrier, and takes the second two 8-bit blocks from each interleaver and allocates the blocks to the other subcarrier, with the additional feature that the destination subcarriers are periodically interchanged.

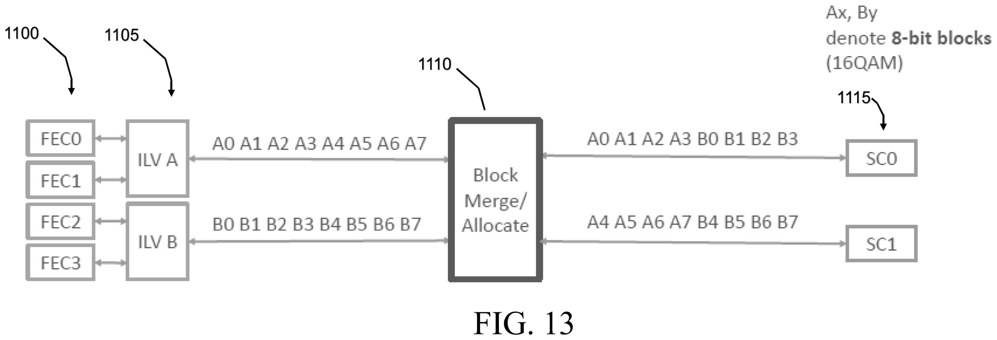

In the example of FIG. 13, there is one scheme. The 64 bits A0A1A2A3B0B1B2B3 go to SC0, the 64 bits A4A5A6A7B4B5B6B7 go to SC1, and the cycle repeats. In each cycle, the process effectively takes the first four 8-bit blocks from each interleaver and allocates the blocks to one subcarrier, and takes the second four 8-bit blocks from each interleaver and allocates the blocks to the other subcarrier.

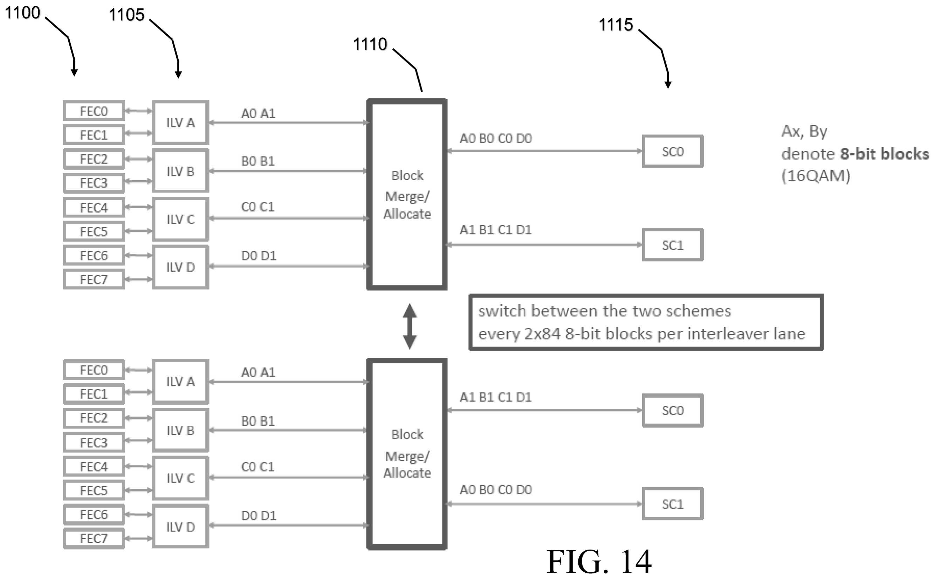

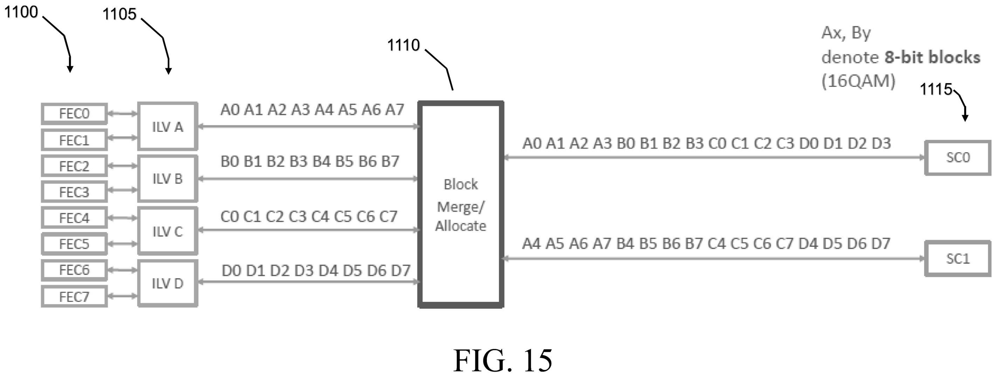

Several embodiments of our new approach relate to systems in which the transmitter side has eight encoders and four interleavers receiving output from respective pairs of the encoders, and the encoded data is mapped to DP-16QAM symbols for transmission on two subcarriers. Examples of such embodiments are provided in FIGS. 14 and 15.

In each of FIGS. 14 and 15, the OFEC encoder functional blocks are collectively called out by the reference numeral **1100,** the interleaver functional blocks are collectively called out by the reference numeral **1105,** the functional block representing the operations of merging and allocating blocks of bits to subcarriers is called out by the reference numeral **1110,** and the subcarrier lanes are collectively called out by the reference numeral **1115.**

The interleavers in FIGS. 14 and 15 are labeled A, B, C, and D. The sequences of 8-bit blocks, i.e., words of DP-16QAM, output from each interleaver are respectively designated A0, A1, etc., B0, B1, etc., C0C1, etc., and D0D1, etc.

In the example of FIG. 14, there are two alternating schemes for allocating 8-bit blocks to subcarriers. The first scheme is a cycle in which the 32 bits A0B0C0D0 go to SC0, the 32 bits A1B1C1D1 go to SC1, and the cycle repeats. The second scheme is a cycle in which the subcarrier lanes exchange position. That is, the 32 bits A1B1C1D1 go to SC0, the 32 bits A0B0C0D0 go to SC1, and the cycle repeats. The process switches between the two schemes whenever 2×84 8-bit blocks in each interleaver lane have been allocated.

In each cycle, the process effectively takes the first 8-bit block from each interleaver and allocates the blocks to one subcarrier, and takes the second 8-bit block from each interleaver and allocates the blocks to the other subcarrier, with the additional feature that the destination subcarriers are periodically interchanged.

In the example of FIG. 15, there is one scheme. The 128 bits
A0A1A2A3B0B1B2B3C0C1C2C3D0D1D2D3
   go to SC0, the 128 bits
A4A5A6A7B4B5B6B7C4C5C6C7D4D5D6D7
go to SC1, and the cycle repeats. In each cycle, the process effectively takes the first four 8-bit blocks from each interleaver and allocates the blocks to one subcarrier, and takes the second four 8-bit blocks from each interleaver and allocates the blocks to the other subcarrier.

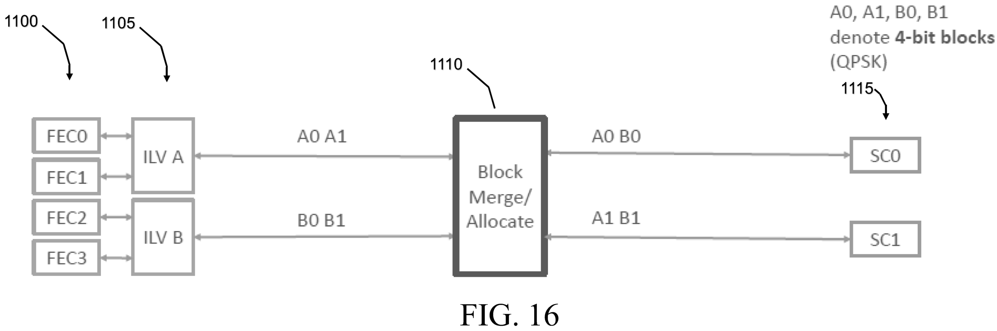

Another embodiment of our new approach relates to systems in which the transmitter side has four encoders and two interleavers receiving output from respective pairs of the encoders, and the encoded data is mapped to DP-QPSK symbols for transmission on two subcarriers. An example of such an embodiment is provided in FIG. 16.

In FIG. 16, the OFEC encoder functional blocks are collectively called out by the reference numeral **1100,** the interleaver functional blocks are collectively called out by the reference numeral **1105,** the functional block representing the operations of merging and allocating blocks of bits to subcarriers is called out by the reference numeral **1110,** and the subcarrier lanes are collectively called out by the reference numeral **1115.**

In the example of FIG. 16, 4-bit blocks, i.e., DP-QPSK words, are allocated to subcarriers. In each cycle, the 8 bits A0B0 are allocated to SC0, and the 8 bits A1B1 are allocated to SC1. In effect, then, the process in each cycle takes the first 4-bit block from each interleaver and allocates it to SC0, and takes the second 4-bit block from each interleaver and allocates it to SC1.

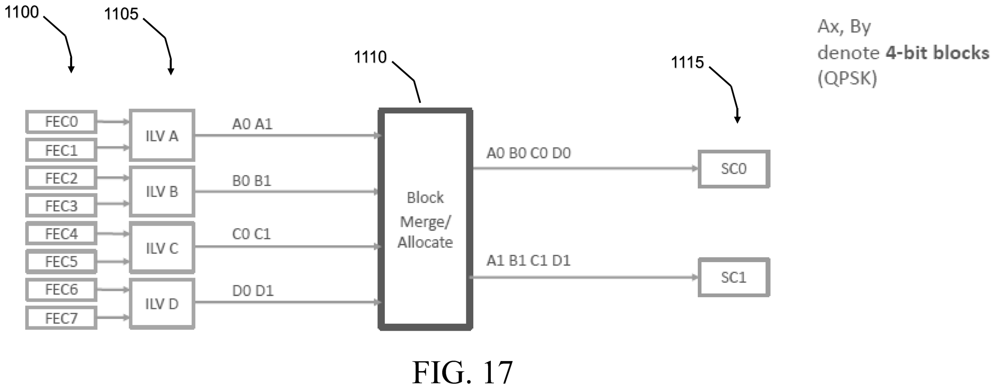

Another embodiment of our new approach relates to systems in which the transmitter side has eight encoders and four interleavers receiving output from respective pairs of the encoders, and the encoded data is mapped to DP-QPSK symbols for transmission on two subcarriers. An example of such an embodiment is provided in FIG. 17.

In FIG. 17, the OFEC encoder functional blocks are collectively called out by the reference numeral **1100,** the interleaver functional blocks are collectively called out by the reference numeral **1105,** the functional block representing the operations of merging and allocating blocks of bits to subcarriers is called out by the reference numeral **1110,** and the subcarrier lanes are collectively called out by the reference numeral **1115.**

In the example of FIG. 17, 4-bit blocks, i.e., DP-QPSK words, are allocated to subcarriers. In each cycle, the 16 bits A0B0C0D0 are allocated to SC0, and the 16 bits A1B1C1D1 are allocated to SC1. In effect, then, the process in each cycle takes the first 4-bit block from each interleaver and allocates it to SC0, and takes the second 4-bit block from each interleaver and allocates it to SC1.

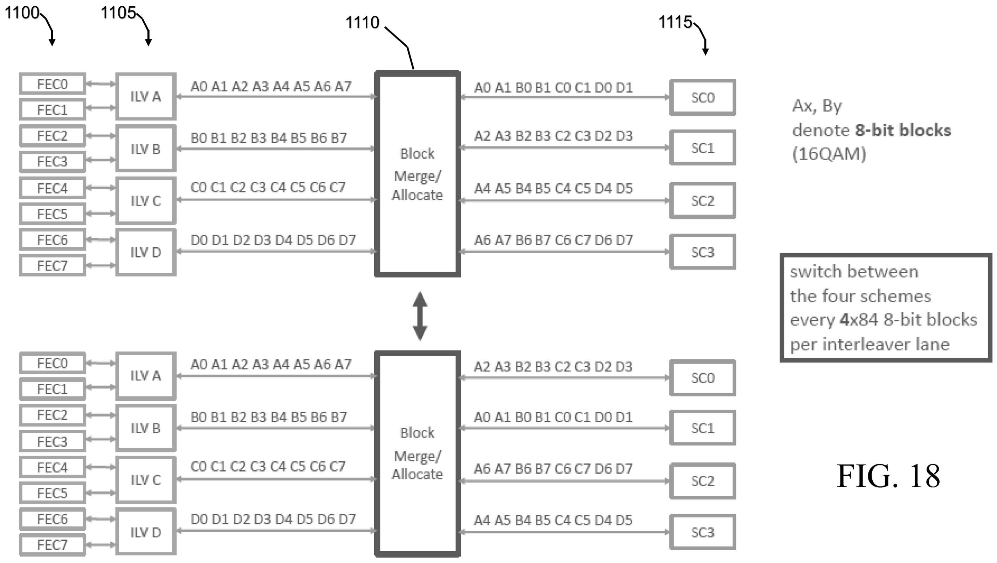

Another embodiment of our new approach relates to systems in which the transmitter side has eight encoders and four interleavers receiving output from respective pairs of the encoders, and the encoded data is mapped to DP-16QAM symbols for transmission on four subcarriers. An example of such an embodiment is provided in FIG. 18, in which the four subcarriers are respectively labeled SC0, SC1, SC2, and SC3.

In FIG. 18, the OFEC encoder functional blocks are collectively called out by the reference numeral **1100,** the interleaver functional blocks are collectively called out by the reference numeral **1105,** the functional block representing the operations of merging and allocating blocks of bits to subcarriers is called out by the reference numeral **1110,** and the subcarrier lanes are collectively called out by the reference numeral **1115.**

In the example of FIG. 18, there are two alternating schemes for allocating 8-bit blocks, i.e., words of DP-16QAM, to subcarriers. The first scheme is a cycle in which the 64 bits A0A1B0B1C0C1D0D1 go to SC0, the 64 bits A2A3B2B3C2C3D2D3 go to SC1, the 64 bits A4A5B4B5C4C5D4D5 go to SC2, the 64 bits A6A7B6B7C6C7D6D7 go to SC3, and the cycle repeats. The second scheme is a cycle in which the first two subcarrier lanes exchange position and the second two subcarrier lanes exchange position. That is, the 64 bits A2A3B2B3C2C3D2D3 go to SC0, the 64 bits A0A1B0B1C0C1D0D1 go to SC1, the 64 bits A6A7B6B7C6C7D6D7 go to SC2, the 64 bits A4A5B4B5C4C5D4D5 go to SC3, and the cycle repeats. The process switches between the two schemes whenever 4×84 8-bit blocks in each interleaver lane have been allocated.

In each cycle, the process effectively takes the first two 8-bit blocks from each interleaver and allocates the blocks to the first subcarrier, takes the second two 8-bit blocks from each interleaver and allocates the blocks to the second subcarrier, takes the third two 8-bit blocks from each interleaver and allocates the blocks to the third subcarrier, and takes the fourth two 8-bit blocks from each interleaver and allocates the blocks to the fourth subcarrier, with the additional feature that the first two destination subcarriers are periodically interchanged and the second two destination subcarriers are periodically interchanged.

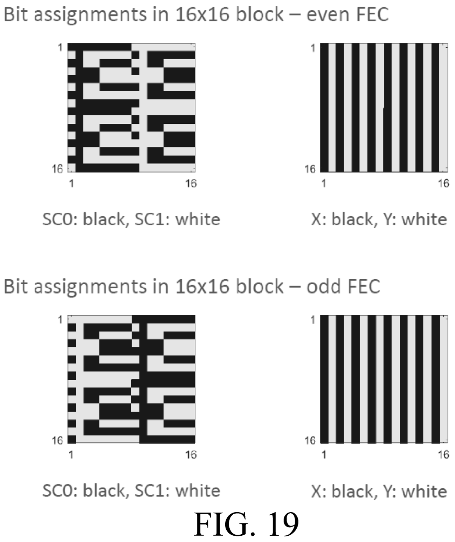

As noted above, we traced OFEC encoder output blocks, i.e., 2×8 blocks of 16×16 bit Square code blocks, through a communication link using the approach shown in FIG. 5, to determine which subcarriers their bits were allocated to, and we found an uneven distribution of bits over subcarriers. For comparison, FIGS. 19-25 show the results of a similar tracing when using the approaches of FIGS. 11-18, respectively.

In FIG. 19, the upper left image represents the bit assignments to subcarriers in each 16×16 bit square code block encoded by the even-numbered encoders of FIG. 11. The upper right image represents the corresponding assignments of polarization channels. The lower left image represents the bit assignments to subcarriers in each 16×16 bit square code block encoded by the odd-numbered encoders of FIG. 11. The lower right image represents the corresponding assignments of polarization channels.

The figure shows that there is the same number of bits from each subcarrier and each polarization channel in each row of each 16×16 square code block. The bit patterns in all 16×16 square code blocks for encoders with even indices are identical, and they are identical for encoders with odd indices. The 16×16 bit patterns for even and odd encoders are flipped with respect to the subcarriers.

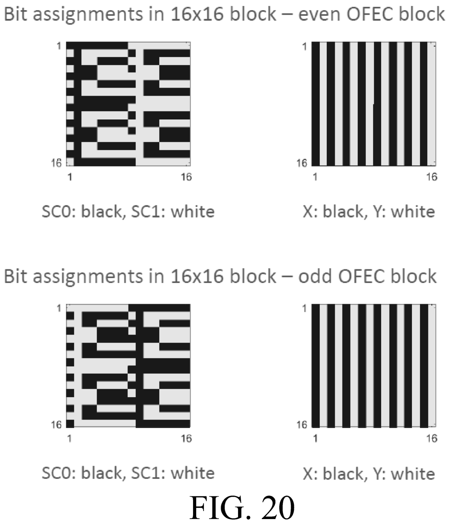

The images in FIG. 20 represent the bit assignments to subcarriers in 16×16 bit square code blocks output by the encoders of FIG. 12. FIG. 20 is best understood if the 2×8 OFEC encoder output blocks (each containing sixteen16×16 bit Square code blocks) corresponding to a given OFEC encoder are considered to be indexed 0, 1, 2, etc. Then the upper left image represents bit assignments for 16×16 bit blocks in even-indexed ones of the 2×8 OFEC encoder output blocks, and the upper right image represents the corresponding assignments of polarization channels. The lower left image represents bit assignments for 16×16 bit blocks in odd-indexed ones of the 2×8 OFEC encoder output blocks, and the lower right image represents the corresponding assignments of polarization channels.

The figure shows that there is the same number of bits from each subcarrier and each polarization channel in each row of each 16×16 block. The bit patterns for all even-indexed OFEC encoder output blocks are identical, and they are identical for all odd-indexed OFEC encoder output blocks. The 16×16 bit patterns for even and odd indices are flipped with respect to the subcarriers.

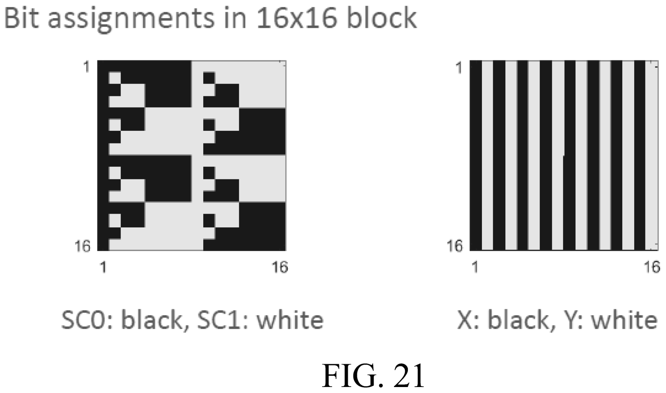

In FIG. 21, the left image represents the bit assignments to subcarriers in each 16×16 bit square code block encoded by the encoders of FIG. 13. The right image represents the corresponding assignments of polarization channels.

The figure shows that there is the same number of bits from each subcarrier and each polarization channel in each row of each 16×16 block. The bit patterns are identical in all 16×16 blocks from all encoders.

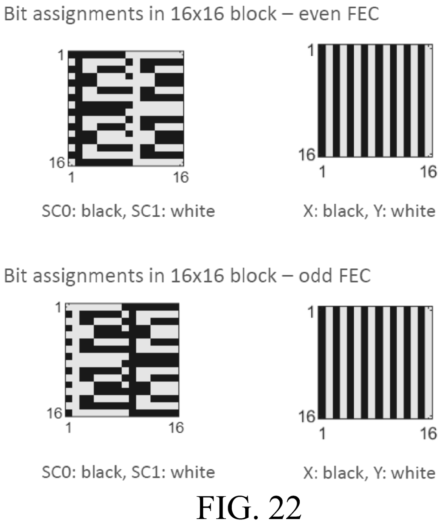

In FIG. 22, the upper left image represents the bit assignments to subcarriers in each 16×16 bit square code block encoded by the even-numbered encoders of FIG. 14. The upper right image represents the corresponding assignments of polarization channels. The lower left image represents the bit assignments to subcarriers in each 16×16 bit square code block encoded by the odd-numbered encoders of FIG. 14. The lower right image represents the corresponding assignments of polarization channels.

The figure shows that there is the same number of bits from each subcarrier and each polarization channel in each row of each 16×16 block. The bit patterns in all 16×16 blocks for encoders with even indices are identical, and they are identical for encoders with odd indices. The 16×16 bit patterns for even and odd encoders are flipped with respect to the subcarriers.

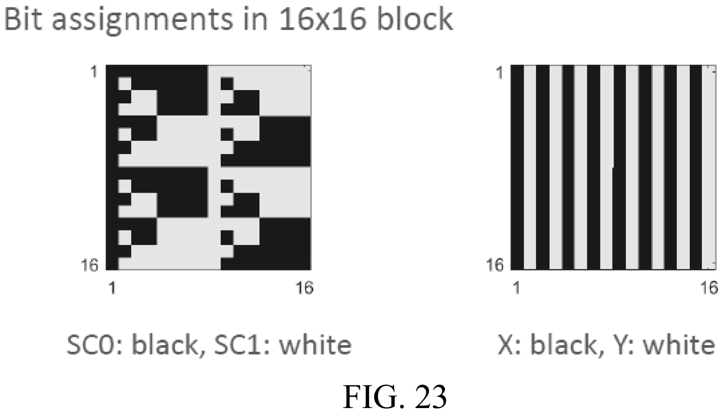

In FIG. 23, the left image represents the bit assignments to subcarriers in each 16×16 bit square code block encoded by the encoders of FIG. 15. The right image represents the corresponding assignments of polarization channels.

The figure shows that there is the same number of bits from each subcarrier and each polarization channel in each row of each 16×16 block. The bit patterns are identical in all 16×16 blocks from all encoders.

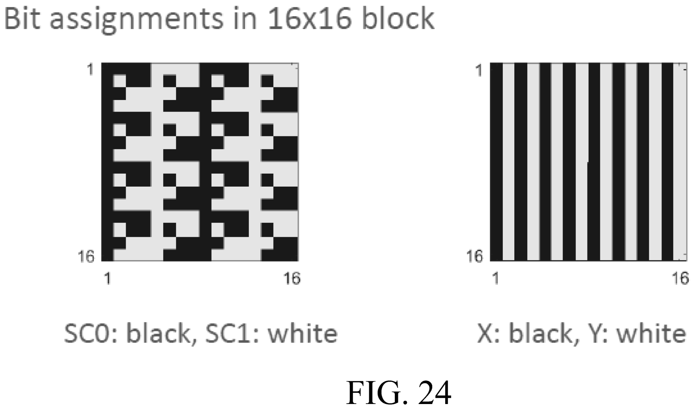

In FIG. 24, the left image represents the bit assignments to subcarriers in each 16×16 bit square code block encoded by the encoders of FIG. 16. The right image represents the corresponding assignments of polarization channels.

The figure shows that there is the same number of bits from each subcarrier and each polarization channel in each row of each 16×16 block. The bit patterns are identical in all 16×16 blocks from all encoders.

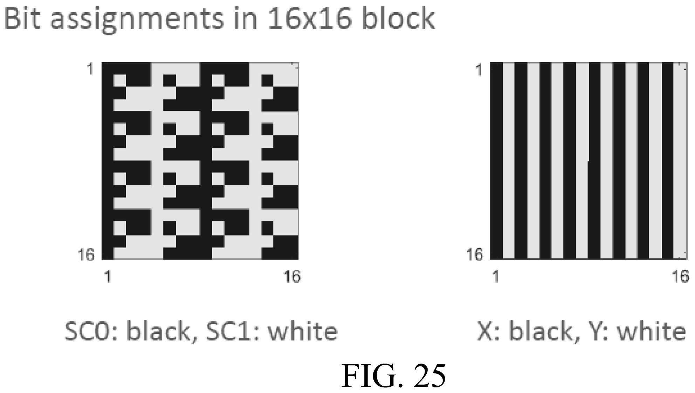

In FIG. 25 the left image represents the bit assignments to subcarriers in each 16×16 bit square code block encoded by the encoders of FIG. 17. The right image represents the corresponding assignments of polarization channels.

The figure shows that there is the same number of bits from each subcarrier and each polarization channel in each row of each 16×16 block. The bit patterns are identical in all 16×16 blocks from all encoders.

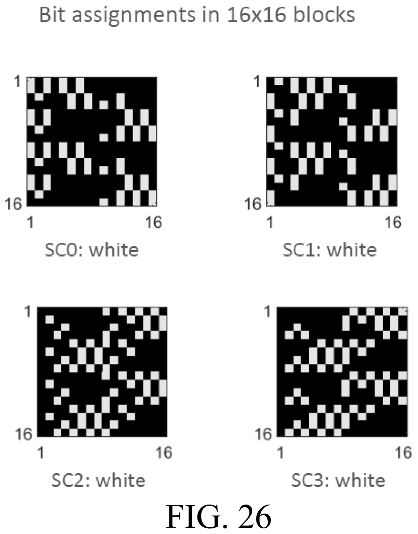

FIG. 26 shows the bit assignments to the respective subcarriers SC0, SC1, SC2, and SC3 in each 16×16 bit square code block encoded by the encoders of FIG. 18. In the upper left image, white squares indicate the assignment to SC0, in the upper right image, white squares indicate the assignment to SC1, in the lower left image, white squares indicate the assignment to SC2, and in the lower right image, white squares indicate the assignment to SC3. In each of the four images, black squares indicate assignments to other subcarriers.

The figure shows that every subcarrier appears exactly four times in each row of each 16×16 block. Although not shown in the figure, we note that there is also the same number of bits for each polarization channel in each row of each 16×16 block. The bit patterns in all 16×16 blocks are identical for all encoders.

Five different configurations, i.e., five different combinations of number of encoders, number of subcarriers, and type of constellation symbol, are considered among the disclosed embodiments. The different configurations are listed in Table 3:

| **Table 3** | | |
|---|---|---|
| **Number of Encoders** | **Number of Subcarriers** | **Type of Constellation Symbol** |
| 4 | 2 | 16QAM |
| 8 | 2 | 16QAM |
| 4 | 2 | QPSK |
| 8 | 2 | QPSK |
| 8 | 4 | 16QAM |

The embodiment of each of FIGS. 11-18 has the result that every row of every 16×16 bit block contains the same number of bits associated to each of the two subcarriers and their polarizations.

For each of the five configurations listed in the table above, there is one embodiment with identical bit distribution for all 16×16 bit square code blocks for all four or all eight FEC encoders and decoders. This feature is advantageous for ease of implementation.

It will be understood from the foregoing that in each of the disclosed embodiments, two or more input streams of sequentially ordered input data units are merged so as to produce at least a first merged stream and a second merged stream of sequentially ordered output data units, and each merged stream is allocated to a respective subcarrier. It will be further understood that
each of the input data units comprises one or more blocks of encoded data, and that in the merging, input data units from the respective input streams are assigned to the respective merged streams by round robin distribution. It will be further understood that each output data unit comprises the encoded data blocks of one input data unit from each of the respective input streams. Those skilled in the art will recognize that many algorithms may be used, in the alternative, to bring about the merged results of the kind described here. All such algorithms are considered to be equivalent and to fall within scope of the present disclosure.

The various embodiments disclosed above differ among themselves in the constitution of the input and output data units. In the embodiment of FIG. 11, for example, the input data units are the 8-bit blocks A0, A1, B0, B1, and the output data units are the 16-bit blocks A0B0 and A1B1.

In the embodiment of FIG. 12, the input data units are the 16-bit blocks A0A1, A2A3, B0B1, B2B3, and the output data units are the 32-bit blocks A0A1B0B1, A2A3B2B3.

In the embodiment of FIG. 13, the input data units are the 32-bit blocks A0A1A2A3, B0B1B2B3, and the output data units are the 64-bit blocks A0A1A2A3B0B1B2B3.

In the embodiment of FIG. 14, the input data units are the 8-bit blocks A0, A1, B0, B1, C0, C1, D0, D1, and the output data units are the 32-bit blocks AOBOCODO, A1B1C1D1.

In the embodiment of FIG. 15, the input data units are the 32-bit blocks A0A1A2A3, A4A5A6A7, B0B1B2B3, B4B5B6B7, C0C1C2C3, C4C5C6C7, D0D1D2D3, D4D5D6D7, and the output data units are the 128-bit blocks A0A1A2A3B0B1B2B3C0C1C2C3D0D1D2D3, A4A5A6A 7B4B5B6B7C4C5C6C7D4D5D6D7.

In the embodiment of FIG. 16, the input data units are the 4-bit blocks A0, A1, B0, B1, and the output data units are the 8-bit blocks AOBO, A1B1.

In the embodiment of FIG. 17, the input data units are the 4-bit blocks A0, A1, B0, B1, C0, C1, D0, D1, and the output data units are the 16-bit blocks AOBOCODO, A1B1C1D1.

In the embodiment of FIG. 18, the input data units are the 16-bit blocks A0A1, A2A3, A4A5, A6A7, B0B1, B2B3, B4B5,B6B7, C0C1, C2C3, C4C5, C6C7, D0D1, D2D3, D4D5, D6D7, and the output data units are the 64-bit blocks A0A1B0B1C0C1D0D1, A2A3B2B3C2C3D2D3, A4AB4B5C4C5D4D5, A6A7B6B7C6C7D6D7.

As those skilled in the art will recognize, various permutations of the output data units, such as those listed above, will preserve the benefits of the disclosed embodiments regarding uniform distribution of bits over subcarriers and polarizations. The permutations referred to here are permutations, within an output data unit, of the basic blocks A0, A1, etc., i.e., the blocks of 8 bits for 16QAM or of 4 bits for QPSK. Any permutation will preserve the abovesaid benefits, and different permutations (or no permutation) may be applied to different subcarrier lanes.

Turning again to FIG. 15, for example, the output data unit allocated to SC0 may be permuted to
A0B0C0D0A1B1C1D1A2B2C2D2A3B3C3D3
without changing the bit-assignment pattern of FIG. 26. Accordingly, all such permutations should be understood as falling within the scope of the current disclosure.

The disclosed embodiments are beneficial for mitigating performance loss due to subcarrier imbalance, i.e., different SNRs on the different subcarriers. Performance loss is mitigated because the LLRs from the two subcarriers are evenly mixed in every BCH decoder at the receiver.

The foregoing merely illustrates the principles of the invention. It will thus be appreciated that those skilled in the art will be able to devise various arrangements that, although not explicitly described or shown herein, embody the principles of the invention and are included within its spirit and scope.

Furthermore, all examples and conditional language recited herein are principally intended expressly to be only for pedagogical purposes to aid the reader in understanding the principles of the invention and the concepts contributed by the inventors to furthering the art, and are to be construed as being without limitation to such specifically recited examples and conditions.

Moreover, all statements herein reciting principles, aspects, and embodiments of the invention, as well as specific examples thereof, are intended to encompass both structural and functional equivalents thereof.

Additionally, it is intended that such equivalents include both currently known equivalents as well as equivalents developed in the future, i.e., any elements developed that perform the same function, regardless of structure. Thus, for example, it will be appreciated by those skilled in the art that any block diagrams herein represent conceptual views of illustrative circuitry embodying the principles of the invention.

In the claims hereof any element expressed as a means for performing a specified function is intended to encompass any way of performing that function. This may include, for example, (a) a combination of electrical or mechanical elements which performs that function, or (b) software in any form, including, therefore, firmware, microcode or the like, combined with appropriate circuitry for executing that software to perform the function, as well as mechanical elements coupled to software controlled circuitry, if any. The invention as defined by such claims resides in the fact that the functionalities provided by the various recited means are combined and brought together in the manner which the claims call for. Applicant thus regards any means which can provide those functionalities as equivalent as those shown herein.

## Claims

1. A method, comprising:
inputting at least an input stream A and an input stream B of sequentially ordered input data units of data encoded by a plurality of OFEC encoders;
merging at least streams A and B so as to produce at least a first merged stream and a second merged stream of sequentially ordered output data units; and
in a first allocation scheme, allocating the first merged stream to an optical subcarrier SC0 of an optical communication system and allocating the second merged stream to an optical subcarrier SC1 of an optical communication system having two polarization channels, wherein:
the optical subcarriers SC0 and SC1 belong to a plurality of at least two optical subcarriers;
each of the input data units comprises one or more blocks of encoded data;
in the merging, input data units from the respective input streams are assigned to the respective merged streams by round robin distribution;
the producing of each of the output data units comprises merging input data units assigned to a given merged stream, such that each output data unit comprises the encoded data blocks of one input data unit from each of the respective input streams; and
the merging and allocating are carried out such that for each OFEC encoder of said OFEC encoder plurality, a same number of bits is allocated to each subcarrier of the subcarrier plurality, and a same number of bits is allocated to each of the two polarization channels.

2. The method of claim 1, further comprising periodically alternating the allocating of merged streams between the first allocation scheme and a second allocation scheme in which the first merged stream is allocated to SC1 and the second merged stream is allocated to SC0.

3. The method of claim 2, wherein each input data unit is an 8-bit DP-16QAM word.

4. The method of claim 2, wherein each input data unit consists of two sequential 8-bit DP-16QAM words.

5. The method of claim 2, wherein each input data unit is an 8-bit DP-16QAM word, there are four input streams A, B, C, and D of sequentially ordered input data units; and streams A, B, C, and D are merged so as to produce a first merged stream and a second merged stream of sequentially ordered output data units.

6. The method of claim 2, wherein:
each input data unit consists of two 8-bit DP-16QAM words;
there are four input streams A, B, C, and D of sequentially ordered input data units;
streams A, B, C, and D are merged so as to produce first, second, third, and fourth merged streams of sequentially ordered output data units;
in the first allocation scheme, the first merged stream is allocated to SC0, the second merged stream is allocated to SC1, the third merged stream is allocated to a third subcarrier SC2 of the subcarrier plurality, and the fourth merged stream is allocated to a fourth subcarrier SC3 of the subcarrier plurality;
in the second allocation scheme, the first merged stream is allocated to SC1, the second merged stream is allocated to SC0, the third merged stream is allocated to a third subcarrier SC3, and the fourth merged stream is allocated to a fourth subcarrier SC4.

7. The method of claim 1, wherein each input data unit consists of four 8-bit DP-16QAM words.

8. The method of claim 7, wherein the merging consists of merging two streams A and B.

9. The method of claim 7, wherein the inputting comprises inputting four input streams A, B, C, and D, and the merging comprises merging the four input streams A, B, C, and D.

10. The method of claim 1, wherein each input data unit consists of one 4-bit DP-QPSK word.

11. The method of claim 10, wherein the merging consists of merging two streams A and B.

12. The method of claim 10, wherein the inputting comprises inputting four input streams A, B, C, and D, and the merging comprises merging the four input streams A, B, C, and D.

13. The method of claim 1, wherein, in the producing of each of the output data units, the merging of input data units assigned to a given merged stream maintains sequential order and contiguity of encoded data blocks within each of the merged input data units.

14. The method of claim 1, wherein each of the input streams of sequentially ordered input data units is generated by interleaving output streams from a respective pair of OFEC encoders.

15. An apparatus comprising means for performing the method of any of claims 1 to 14.
